Europäisches Patentamt

(19) European Patent Office

Office européen des brevets

(11) Publication number: **0 297 638 B1**

# EUROPEAN PATENT SPECIFICATION

(12)

(45) Date of publication of patent specification :
**11.12.91 Bulletin 91/50**

(51) Int. Cl.⁵ : **H03K 3/356, H03K 5/24,**
**G01R 19/165**

(21) Application number : **88201127.3**

(22) Date of filing : **04.06.88**

(54) **Three-state device and comparator device using same.**

(30) Priority : **30.06.87 BE 8700734**

(43) Date of publication of application :
**04.01.89 Bulletin 89/01**

(45) Publication of the grant of the patent :
**11.12.91 Bulletin 91/50**

(84) Designated Contracting States :
**BE DE IT**

(56) References cited :
**DE-A- 3 337 110**
**DE-A- 3 442 649**
**US-A- 4 247 791**
**US-A- 4 511 810**
**US-A- 4 542 308**
**PATENT ABSTRACTS OF JAPAN, volume 5,
no. 179 (E-82)[851], 17th November 1981 &
JP-A-56-106 425**
**PATENT ABSTRACTS OF JAPAN, volume 9,
no. 185 (E-332)[1908], 31st July 1985 & JP-A-
60-55725**
**PATENT ABSTRACTS OF JAPAN, volume 9,
no. 298 (E-361)[2021], 26th November 1985 &
JP-A-60-137 119**

(73) Proprietor : **ALCATEL N.V.**
**Strawinskylaan 537 (World Trade Center)**
**NL-1077 XX Amsterdam (NL)**
(84) Designated Contracting States :
**DE IT**
Proprietor : **BELL TELEPHONE**
**MANUFACTURING COMPANY Naamloze**
**Vennootschap**
**Francis Wellesplein 1**
**B-2018 Antwerp (BE)**
(84) Designated Contracting States :
**BE**

(72) Inventor : **De Ceulaer, Bart Jozef Maria**
**Cardijnlaan 21**
**B-2288 Grobbendonk (BE)**
Inventor : **Sallaerts, Daniel**
**Steenweg op St. Joris Winge 14**
**B-3220 Aarschot (BE)**

(74) Representative : **Vermeersch, Robert et al**
**BELL TELEPHONE MANUFACTURING**
**COMPANY Naamloze Vennootschap Patent**
**Department Francis Wellesplein 1**
**B-2018 Antwerpen (BE)**

EP 0 297 638 B1

## Description

The present invention relates to a three-state device with a bistate circuit which when operating brings its outputs on respective ones of first and second voltages and with control means including switching first transistors coupling said outputs with a predetermined voltage and able to prevent the operation of said bistate circuit by bringing said outputs on said predetermined voltage and to disconnect said predetermined voltage from said outputs respectively, said bistate circuit including two branches which are coupled between said first and second voltages and are each constituted by the series connection of at least one impedance and the input/output electrode path of a second transistor, the junction points of said impedances and said second transistors constituting said outputs which are cross-coupled with control electrodes of said second transistors.

Such a three-state device is already known from the German Offenlegungsschrift DE 3337110 and is operated in function of the difference in magnitude of input currents flowing through the impedances. The second voltage also constitutes the predetermined voltage and when the first transistors are operated they connect the outputs of the bistate circuit to the second voltage and thereby short-circuit the second transistors which are MOS transistors and thus prevent the operation of the bistate circuit. In this condition a current nevertheless continues flowing through the impedances so that the second transistors of the bistate circuit will be rapidly operated when afterwards the first transistors are again disabled and thereby remove the short-circuit from the second transistors. However, to further increase the operation speed additional means have been associated to the three-state device to increase, by a same amount, the magnitude of the input currents. In this way the gate-to-source capacitances of the second transistors are charged more rapidly after the removal of the short-circuit and therefore start conducting more rapidly.

These additional means make the device more complex and the additional currents have to be exactly equal since they otherwise adversely affect the input current comparison and might in the limit cases, where the difference of the input currents to be compared is very small, switch the circuit into an erroneous state.

An object of the invention is to provide a three-state device of the above described type, but having a relatively high operation speed without requiring means providing additional currents.

According to the invention this object is achieved due to the fact that said control means further include a third transistor coupling said two branches with said second voltage and control said first and third transistors in such a way that when the first transistors are operated the third transistor is disabled and vice-versa, and said predetermined voltage being halfway between said first and second voltages.

Thus just as in the known device a current continuously flows through the impedances either via the second and third transistors in series or through the first transistors thus enhancing the operation speed. But the latter is further increased on the one hand because the second transistors are prevented from being operated by the third transistor without being short-circuited and on the other hand because the outputs are then connected by the first transistors to the predetermined voltage which is halfway between the first and second voltages. Indeed, when afterwards the predetermined voltage is switched off by the first transistors and the third transistor is switched on the second transistors become immediately conductive and because the voltage on their outputs evolve towards respective ones of the first and second voltage by a relatively small change the operation or switching speed of the circuit is correspondingly high.

It should be noted that the Japanese patent application JP-A-6055725 already discloses a three-state device with a bistate circuit having impedances and second transistors connected in the way described above, and with control means including first transistors to bring an output of the bistate circuit on a predetermined voltage halfway between first and second voltages when the operation of the bistate circuit is inhibited. However, in this known three-state device the impedances are not coupled in series neither with the first transistors nor with a third transistor controlling the operation of the bistate circuit. As a result a current enhancing the operation speed of the bistate circuit does not continuously flow through the impedances.

The above mentioned and other objects and features of the invention will become more apparent and the invention itself will be best understood by referring to the following description of an embodiment taken in conjunction with the acompanying drawings which represents a three-state device according to the invention.

This three-state device operates with the DC supply voltages VDD = 5 Volts, VSS = 0 Volt and VAG = 2.5 Volts and has a difference input with plus terminal IN1 and minus terminal IN2 and a difference output with terminals OUT1 and OUT2. The device includes an input circuit constituted by a difference amplifier DA, a bistate circuit or flipflop FF and control means CC provided with a clock circuit CLC, DA, FF and CC include PMOS transistors PM1 to PM6 and NMOS transistors NM1 to NM9.

The difference amplifier DA includes PMOS transistors PM1 and PM2 whose gates constitute the input terminals IN1 and IN2 respectively. The supply voltage VDD is connected to the source electrodes of PM1 and PM2 via the common current source CS, whilst their drain electrodes are connected to the supply voltage VSS via the diode connected transistors NM1 and NM2 respectively.

The flipflop FF includes two branches coupled between VDD and VSS and each formed by the series connection of an impedance constituted by the source-to-drain path of a PMOS transistor PM5 ; PM6 and the drain-to-source path of an NMOS transistor NM5 ; NM6 The drain and gate electrodes of the latter transistors are cross-connected and their drain electrodes constitute the output terminals OUT1 and OUT2. The source electrodes of NM5 and NM6 are interconnected and coupled to VSS.

Each of the transistors NM1 ; NM2 of the difference amplifier DA is connected in current mirror configuration via the transistor NM3 ; NM4 and the diode connected transistor PM3 ; PM4 with the transistor PM5 ; PM6 of FF.

The control means CC include the NMOS switching transistors NM7, NM8 and NM9 and the clock circuit CLC. The drain-to-source paths of NM7 and NM8 are coupled between OUT1 and VAG and OUT2 and VAG respectively, whilst the drain-to-source path of NM9 couples the source electrodes of NM5 and NM6 with VSS. The clock circuit CLC provides the clock pulses $\overline{CL}$ and CL which are phase-shifted over 180 degrees and which control the gates of NM7/8 and NM9 respectively.

The operation of the above described three-state device is as follows.

When an input voltage is applied across the input terminal IN1 and IN2 of the difference amplifier DA then the total current I1 + I2 provided by the current source CS is subdivided, in function of the input voltage, in two currents I1 and I2 flowing through PM1, NM1 and PM2, NM2 respectively. These currents are mirrored via NM3, PM3 and NM4, PM4 in the transistors PM5 and PM6 of the flipflop FF respectively, so that the currents supplied to the transistors NM5 and NM6 are equal to I1 and I2 respectively.

The control means CC normally prevent the operation of the flipflop FF because the clock circuit CLC then respectively makes conductive the switching transistors NM7/8 by means of an active (1) pulse of $\overline{CL}$ and blocks the switching transistor NM9 by means of a non-active pulse (0) of CL. Thereby the outputs OUT1 and OUT2 of the device are brought on a voltage VAG halfway between VDD and VSS and the source electrodes of NM5/6 are disconnected from VSS due to which they are substantially at the voltage VAG.

The control means CC enables the operation of the flipflop FF when the clock circuit CLC respectively blocks the switching transistors NM7/8 by means of a non-active (0) pulse of $\overline{CL}$ and make switching transistor NM9 conductive with the help of an active pulse (1) of CL. Thereby the voltage VAG is disconnected from the outputs OUT1 and OUT2 and the voltage VSS is connected to the source electrodes of NM5/6.

As a consequence both transistors NM5/6 immediately become conductive and the voltages on the outputs immediately and very rapidly evolve from VAG to the respective voltages VDD and VSS, due to which the flipflop FF is thus brought in one of its stable conditions.

From the above it follows that the described device is also a comparator device of the currents I1 and I2 derived in the difference amplifier DA from a difference input voltage.

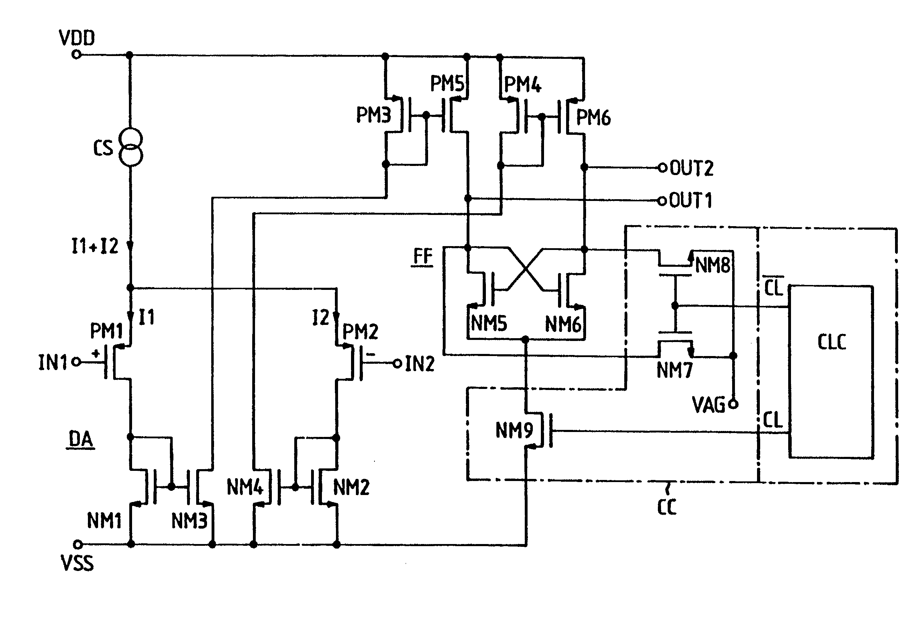

## Claims

1. Three-state device (FF, CC) with a bistate circuit (FF) which when operating brings its outputs (OUT1/2) on respective ones of first (VDD) and second (VSS) voltages and with control means (CC) including switching first transistors (NM7/8) coupling said outputs (OUT1/2) with a predetermined voltage (VAG) and able to prevent the operation of said bistate circuit by bringing said outputs on said predetermined voltage (VAG) and to disconnect said predetermined voltage (VAG) from said outputs, said bistate circuit (FF) including two branches (PM5, NM5 ; PM6, NM6) which are coupled between said first and second voltages and are each constituted by the series connection of at least one impedance (PM5/6) and the input/output electrode path of a second transistor (NM5/6), the junction points of said impedances (PM5/6) and said second transistors (NM5/6) constituting said outputs (OUT1/2) which are cross-coupled with control electrodes of said second transistors (NM5/6), characterized in that said control means further include a third transistor (NM9) coupling said two branches (PM5, NM5 ; PM6, NM6) with said second voltage (VSS) and control said first (NM7/8) and third (NM9) transistors in such a way that when the first transistors are operated the third transistor is disabled and vice-versa, and said predetermined voltage (VAG) being halfway between said first (VDD) and second (VSS) voltages.

2. Three-state device according to claim 1, characterized in that it further includes an input circuit (DA) which provides two currents (I1, I2) to be compared and which is so coupled with said impedances which are constituted by fourth transistors (PM5/6) that said currents flow therein.

3. Three-state device according to claim 2, characterized in that said input circuit (DA) is a differential amplifier wherein a voltage difference is converted into said two currents (I1, I2) to be compared.

4. Three-state device according to claim 2 or 3, characterized by its use as a comparator device for the comparison of said two currents.

## Patentansprüche

1. Drei-Zustandsvorrichtung (FF, CC) mit einem bistabilen Schaltkreis (FF), der, soweit er aktiviert ist, seine Ausgänge (OUT1/2) jeweils mit einer ersten (VDD) und einer zweiten (VSS) Spannung versorgt, mit einer Steuervorrichtung (CC), die erste Schalttransistoren (NM7/8) enthält, über die die Ausgänge (OUT1/2) mit einer vorgegebenen Spannung (VAG) verbindbar sind und die es ermöglichen, die Aktivierung des bistabilen Schaltkreises zu verhindern, indem sie die Ausgänge mit der vorgegebenen Spannung verbindet, und die es ermöglichen, die Verbindung zwischen der vorgegebenen Spannung (VAG) und den Ausgängen (OUT1/2) zu unterbrechen, der bistabile Schaltkreis (FF) zwei Zweige (PM5, NM5 ; PM6, NM6) enthält, die zwischen der ersten Spannung (VDD) und der zweiten Spannung (VSS) angeordnet sind, und jeder Zweig aus einer Serienschaltung mit wenigstens einer Impedanz (PM5/6) und dem Weg zwischen Eingangs- und Ausgangselektrode eines zweiten Transistors (NM5/6) besteht, die Verbindungspunkte der Impedanzen (PM5/6) mit den zweiten Transistoren (NM5/6) die Ausgänge (OUT1/2) bilden, die überkreuz mit den Steuerelektroden der zweiten Transistoren (NM5/6) verbunden sind ; **dadurch gekennzeichnet, daß** die Steuervorrichtung (CC) zusätzlich einen dritten Transistor (NM9) enthält, der die beiden Zweige (PM5, NM5 ; PM6, NM6) mit der zweiten Spannung (VSS) verbindet und die ersten Transistoren (NM7/8) und den dritten Transistor (NM9) derart ansteuert, daß, wenn die ersten Transistoren (NM)7/8) leitend sind, der dritte Transsitor (NM9) sperrt und umgekehrt, und der Wert der vorgegebenen Spannung (VAG) in der Mitte zwischen den Werten der ersten (VDD) und der zweiten Spannung (VSS) liegt.

2. Drei-Zustandsvorrichtung nach Anspruch 1, dadurch gekennzeichnet, daß sie zusätzlich eine Eingangsschaltung (DA) enthält, die zwei miteinander zu vergleichende Ströme (I1, I2) liefert und die so mit den Impedanzen der zweiten Transistoren (PM5/6) verbunden ist, daß die Ströme in diese hineinfließen.

3. Drei-Zustandsvorrichtung nach Anspruch 2, dadurch gekennzeichnet, daß die Eingangsschaltung (DA) ein Differenzverstärker ist, in dem eine Spannungsdifferenz in die zwei, zu vergleichenden Ströme (I1, I2) umgewandelt wird.

4. Drei-Zustandsvorrichtung nach Anspruch 2 oder 3, dadurch gekennzeichnet, daß sie als Komparator zum Vergleichen der beiden Ströme (I1, I2) ausgestaltet ist.

## Revendications

1. Dispositif à trois états (FF, CC) avec un circuit à deux états (FF) qui, lorsqu'il fonctionne, amène ses sorties (OUT1/2) respectivement à des première (VDD) et seconde (VSS) tensions, et avec des moyens de commande (CC) comprenant des premiers transistors de commutation (NM7/8) couplant lesdites sorties (OUT1/2) à une tension prédéterminée (VAG) et capable d'empêcher le fonctionnement dudit circuit à deux états en amenant lesdites sorties à ladite tension prédéterminée (VAG) et capable de déconnecter ladite tension prédéterminée (VAG) desdites sorties, ledit circuit à deux états (FF) comprenant deux branches (PM5, NM5 ; PM6, NM6) qui sont couplées entre lesdites première et seconde tensions et sont chacunes constituées par la connexion en série d'au moins une impédance (PM5/6) et le chemin d'électrode entrée/sortie d'un second transistor (NM5/6), les points de jonction desdites impédances (PM5/6) et desdits seconds transistors (NM5/6) formant lesdites sorties (OUT1/2) qui sont intercouplées avec des électrodes de commande desdits seconds transistors (NM5/6), caractérisé en ce que lesdits moyens de commande comprennent également un troisième transistor (NM9) couplant lesdits deux branches (PM5, NM5 ; PM6, NM6) à ladite seconde tension (VSS) et commandent lesdits premiers (NM7/8) et troisième (NM9) transistors de telle manière que, lorsque les premiers transistors fonctionnent, le troisième transistor est hors fonctionnement et vice-versa, et cette dite tension prédéterminée (VAG) se situant à mi-chemin entre lesdites première (VDD) et seconde (VSS) tensions.

2. Dispositif à trois états selon la revendication 1, caractérisé en ce qu'il comprend en outre un circuit d'entrée (DA) qui fournit deux courants (I1, I2) à comparer et qui est couplé auxdites impédances qui sont constituées par quatre transistors (PM5/6) de telle sorte que lesdits courants y circulent.

3. Dispositif à trois états selon la revendication 2, caractérisé en ce que ledit circuit d'entrée (DA) est un amplificateur différentiel dans lequel une différence de tension est convertie en lesdits deux courants (I1, I2) à comparer.

4. Dispositif à trois états selon la revendication 2 ou 3, caractérisé par son utilisation comme dispositif comparateur pour la comparaison desdits deux courants.